# EUROPEAN PATENT SPECIFICATION

(11) **EP 3 902 006 B1**
(45) Date of publication and mention of the grant of the patent: **31.12.2025**
(21) Application number: 21180167.5
(22) Date of filing: 31.03.2017
(51) Int. Cl.: H10H 29/45, H10H 29/851, H10H 29/855

(54) **DISPLAY DEVICE**
ANZEIGEVORRICHTUNG
AFFICHEUR

(30) Priority: 01.04.2016 US 201662316927 P
(43) Date of publication of application: 27.10.2021
(62) Divisional of application: 17775902.4
(73) Proprietor: Seoul Semiconductor Co., Ltd., Gyeonggi-do 15429 (KR)
(72) Inventor: TAKEYA, Motonobu, 15429 Ansan-si (KR); LEE, Jong Ik, 15429 Ansan-si (KR); KIM, Young Hyun, 15429 Ansan-si (KR)
(74) Representative: Stolmár & Partner Patentanwälte PartG mbB

(56) References cited:
- EP-A1- 3 328 162
- KR-A- 20130 137 985
- US-A1- 2008 246 902
- US-A1- 2015 054 008

## Description

### [Technical Field]

The present invention relates to a display apparatus and more particularly, to a display apparatus using micro-light emitting diodes.

### [Background Art]

A light emitting diode refers to an inorganic semiconductor device that emits light through recombination of electrons and holes and has recently been used in various fields including displays, automobile lamps, general lighting, and the like. Such a light emitting diode has various advantages such as long lifespan, low power consumption, and rapid response. As a result, a light emitting device using a light emitting diode is used as a light source in various fields.

Recently, smart TVs or monitors realize colors using a thin film transistor liquid crystal display (TFT LCD) panel and tend to use light emitting diodes (LEDs) as a light source for a backlight unit for color realization. In addition, a display apparatus is often manufactured using organic light emitting diodes (OLEDs).

In a TFT-LCD, since one LED is used as a light source for many pixels, a backlight light source must be kept in a turned-on state. As a result, the TFT-LCD suffers from constant power consumption regardless of brightness of a displayed screen. On the other hand, although power consumption of an OLED has been continuously reduced due to the development of technology, the OLED still has much higher power consumption than LEDs formed of inorganic semiconductors and thus has low efficiency.

Moreover, a PM drive type OLED can suffer from deterioration in response speed upon pulse amplitude modulation (PAM) of the OLED having large capacitance, and can suffer from deterioration in lifespan upon high current driving through pulse width modulation (PWM) for realizing a low duty ratio. Moreover, an AM driving type OLED requires connection of TFTs for each pixel, thereby causing increase in manufacturing costs and non-uniform brightness according to characteristics of TFTs.

Patent document KR 1020130137985 A discloses a display device with a TFT substrate, a plurality of LEDs disposed on the TFT substrate, and a light conversion layer disposed on the LEDs.

Patent application EP 3328162 A1 discloses a display apparatus including a first substrate including a light emitting diode part including a plurality of light emitting diodes regularly arranged on the first substrate; and a second substrate including a TFT panel unit including a plurality of TFTs driving the light emitting diodes, wherein the first substrate and the second substrate are coupled to each other so as to face each other such that the light emitting diodes are electrically connected to the TFTs, respectively.

### [Disclosure]

### [Technical Problem]

Exemplary embodiments of the present disclosure provide a display apparatus using micro-light emitting diodes having low power consumption to be applicable to a wearable apparatus, a smartphone or a TV, and a method of manufacturing the same.

### [Technical Solution]

The present invention provides a display apparatus according to claim 1.

### Exemplary embodiments

of the present invention are defined in dependent claims 2-13.

### [Advantageous Effects]

According to exemplary embodiments, the display apparatus employs micro-light emitting diodes formed of nitride semiconductors and thus can provide high efficiency and high resolution to be applicable to a wearable apparatus while reducing power consumption.

**In** addition, the display apparatus according to the exemplary embodiments includes a color filter in order to block some fraction of light not subjected to wavelength conversion when light emitted from light emitting diodes is subjected to wavelength conversion while passing through a phosphor layer, thereby improving color purity of light emitted to the outside.

### [Description of Drawings]

FIG. 1 is a sectional view of a display apparatus according to a first exemplary embodiment of the present disclosure.
FIG. 2 is sectional views illustrating a method of manufacturing the display apparatus according to the first exemplary embodiment of the present disclosure.
FIG. 3 is a sectional view of a display apparatus according to a second exemplary embodiment of the present disclosure.
FIG. 4 is a sectional view of a display apparatus according to a third exemplary embodiment of the present disclosure.
FIG. 5 is a sectional view of a display apparatus according to a fourth exemplary embodiment of the present disclosure.

### [Best Mode]

In accordance with the present invention, a display apparatus includes: a first substrate including a plurality of light emitting diodes regularly arranged thereon; a second substrate including a TFT panel part including a plurality of TFTs driving the plurality of light emitting diodes; and a third substrate including a light converter converting light emitted from the first substrate, wherein the first substrate and the second substrate are coupled to each other so as to face each other; the light emitting diodes are electrically connected to the TFTs, respectively; the first substrate and the third substrate are coupled to each other so as to face each other; and light emitted from the plurality of light emitting diodes is converted into at least one of blue light, green light, and red light through the light converter.

The first substrate may include a plurality of support substrates; the plurality of light emitting diodes disposed on the plurality of support substrates, respectively; and a blocking portion disposed between the plurality of support substrates and blocking light emitted from the plurality of light emitting diodes.

The light converter may include a phosphor layer converting wavelengths of light emitted from the light emitting diodes; and a filter unit blocking light of a predetermined wavelength among light having passed through the phosphor layer.

The light emitting diodes may include blue light emitting diodes emitting blue light; the phosphor layer may include a green phosphor layer emitting green light through wavelength conversion of blue light emitted from the blue light emitting diodes, a red phosphor layer emitting red light through wavelength conversion of blue light emitted from the blue light emitting diodes, and a transparent layer allowing blue light emitted from the blue light emitting diodes to pass therethrough without wavelength conversion; the filter unit may include a green light portion disposed on the green phosphor layer and blocking light of a predetermined wavelength among light having passed through the green phosphor layer, a red light portion disposed on the red phosphor layer and blocking light of a predetermined wavelength among light having passed through the red phosphor layer, and a transparent portion disposed on the transparent layer and allowing light having passed through the transparent layer to pass therethrough without wavelength conversion.

The phosphor layer may further include a blocking layer disposed between the green phosphor layer, the red phosphor layer and the transparent layer, and the filter unit may further include a light blocking portion disposed between the green light portion, the red light portion and the transparent portion.

The green light portion may allow only green light to pass therethrough and the red light portion may allow only red light to pass therethrough.

The light emitting diodes may include blue light emitting diodes emitting blue light; the phosphor layer may include a green phosphor layer emitting green light through wavelength conversion of blue light emitted from the blue light emitting diodes, a red phosphor layer emitting red light through wavelength conversion of blue light emitted from the blue light emitting diodes, and a transparent layer allowing blue light emitted from the blue light emitting diodes to pass therethrough without wavelength conversion; and the filter unit may include wavelength filter units disposed on the green phosphor layer and the red phosphor layer, respectively, and blocking light of a predetermined wavelength among light having passed through the green phosphor layer and the red phosphor layer, and a transparent portion disposed on the transparent layer and allowing light having passed through the transparent layer to pass therethrough without wavelength conversion.

The wavelength filter unit may allow green light and red light to pass therethrough and may block blue light.

The light emitting diodes may include blue light emitting diodes emitting blue light; the phosphor layer may include a green phosphor layer emitting green light through wavelength conversion of blue light emitted from the blue light emitting diodes, a red phosphor layer emitting red light through wavelength conversion of blue light emitted from the blue light emitting diodes, a transparent layer allowing blue light emitted from the blue light emitting diodes to pass therethrough without wavelength conversion, and a white phosphor layer converting the wavelength of blue light emitted from the blue light emitting diodes; and the filter unit may include may include a green light portion disposed on the green phosphor layer and blocking light of a predetermined wavelength among light having passed through the green phosphor layer, a red light portion disposed on the red phosphor layer and blocking light of a predetermined wavelength among light having passed through the red phosphor layer, and a transparent portion disposed on the transparent layer and the white phosphor layer and allowing light having passed through the transparent layer and the white phosphor layer to pass therethrough without wavelength conversion.

The light emitting diodes include UV light emitting diodes emitting UV light; the phosphor layer may include a blue phosphor layer emitting blue light through wavelength conversion of UV light emitted from the UV light emitting diodes, a green phosphor layer emitting green light through wavelength conversion of UV light emitted from the UV light emitting diodes, and a red phosphor layer emitting red light through wavelength conversion of UV light emitted from the UV light emitting diodes; and the filter unit may include a blue light portion disposed on the blue phosphor layer and blocking light of a predetermined wavelength among light having passed through the blue phosphor layer, a green light portion disposed on the green phosphor layer and blocking light of a predetermined wavelength among light having passed through the green phosphor layer, and a red light portion disposed on the red phosphor layer and blocking light of a predetermined wavelength among light having passed through the red phosphor layer.

The blue light portion may allow only blue light to pass therethrough, the green light portion may allow only green light to pass therethrough, and the red light portion may allow only red light to pass therethrough.

Each of the plurality of light emitting diodes may include an n-type semiconductor layer; a p-type semiconductor layer; an active layer interposed between the n-type semiconductor layer and the p-type semiconductor layer; an n-type electrode coupled to the n-type semiconductor layer; and a p-type electrode coupled to the p-type semiconductor layer.

The display apparatus may further include an anisotropic conductive film electrically connecting the first substrate to the second substrate.

In accordance with another example not forming part of the present invention, a method of manufacturing a display apparatus includes: forming a first substrate having a plurality of light emitting diodes regularly arranged thereon; forming a second substrate including a TFT panel part including a plurality of TFTs driving the plurality of light emitting diodes; forming a third substrate including a light converter converting light emitted from the first substrate; and coupling the first to third substrates to one another, wherein light emitted from the plurality of light emitting diodes may be converted into one of blue light, green light and red light through the light converter.

The first substrate and the second substrate may be coupled to each other to face each other such that the light emitting diodes are electrically connected to the TFTs, respectively, and the first substrate may be coupled to the third substrate to face each other.

Forming the third substrate may include forming a filter unit on a protective substrate, the filter unit blocking light of a predetermined wavelength among light passing therethrough on a protective substrate; and forming a phosphor layer on the filter unit, the phosphor layer converting the wavelength of light passing therethrough.

The light emitting diodes may include blue light emitting diodes; the phosphor layer may include a green phosphor layer emitting green light through wavelength conversion of blue light emitted from the blue light emitting diodes, a red phosphor layer emitting red light through wavelength conversion of blue light emitted from the blue light emitting diodes, and a transparent layer allowing blue light emitted from the blue light emitting diodes to pass therethrough without wavelength conversion; and the filter unit may include a green light portion disposed on the green phosphor layer and blocking light of a predetermined wavelength among light having passed through the green phosphor layer, a red light portion disposed on the red phosphor layer and blocking light of a predetermined wavelength among light having passed through the red phosphor layer, and a transparent portion disposed on the transparent layer and allowing light having passed through the transparent layer to pass therethrough without wavelength conversion.

The light emitting diodes may include blue light emitting diodes; the phosphor layer may include a green phosphor layer emitting green light through wavelength conversion of blue light emitted from the blue light emitting diodes, a red phosphor layer emitting red light through wavelength conversion of blue light emitted from the blue light emitting diodes, and a transparent layer allowing blue light emitted from the blue light emitting diodes to pass therethrough without wavelength conversion; and the filter unit may include wavelength filter units disposed on the green phosphor layer and the red phosphor layer, respectively, and blocking light of a predetermined wavelength among light having passed through the green phosphor layer and the red phosphor layer, and a transparent portion disposed on the transparent layer and allowing light having passed through the transparent layer to pass therethrough without wavelength conversion.

The light emitting diodes may include blue light emitting diodes; the phosphor layer may include a green phosphor layer emitting green light through wavelength conversion of blue light emitted from the blue light emitting diodes, a red phosphor layer emitting red light through wavelength conversion of blue light emitted from the blue light emitting diodes, a transparent layer allowing blue light emitted from the blue light emitting diodes to pass therethrough without wavelength conversion, and a white phosphor layer emitting white light through wavelength conversion of blue light emitted from the blue light emitting diodes; and the filter unit may include a green light portion disposed on the green phosphor layer and blocking light of a predetermined wavelength among light having passed through the green phosphor layer, a red light portion disposed on the red phosphor layer and blocking light of a predetermined wavelength among light having passed through the red phosphor layer, and a transparent portion disposed on the transparent layer and the white phosphor layer and allowing light having passed through the transparent layer and the white phosphor layer to pass therethrough without wavelength conversion.

The light emitting diodes may include UV light emitting diodes emitting UV light; the phosphor layer may include a blue phosphor layer emitting blue light through wavelength conversion of UV light emitted from the UV light emitting diodes, a green phosphor layer emitting green light through wavelength conversion of UV light emitted from the UV light emitting diodes, and a red phosphor layer emitting red light through wavelength conversion of UV light emitted from the UV light emitting diodes; and the filter unit may include a blue light portion disposed on the blue phosphor layer and blocking light of a predetermined wavelength among light having passed through the blue phosphor layer, a green light portion disposed on the green phosphor layer and blocking light of a predetermined wavelength among light having passed through the green phosphor layer, and a red light portion disposed on the red phosphor layer and blocking light of a predetermined wavelength among light having passed through the red phosphor layer.

Hereinafter, exemplary embodiments of the present disclosure will be described in detail with reference to the accompanying drawings.

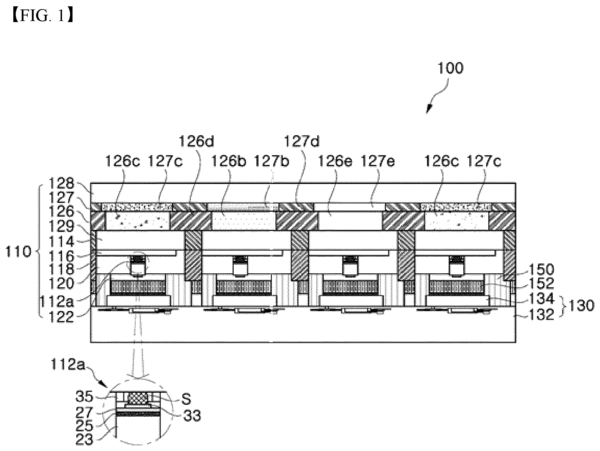

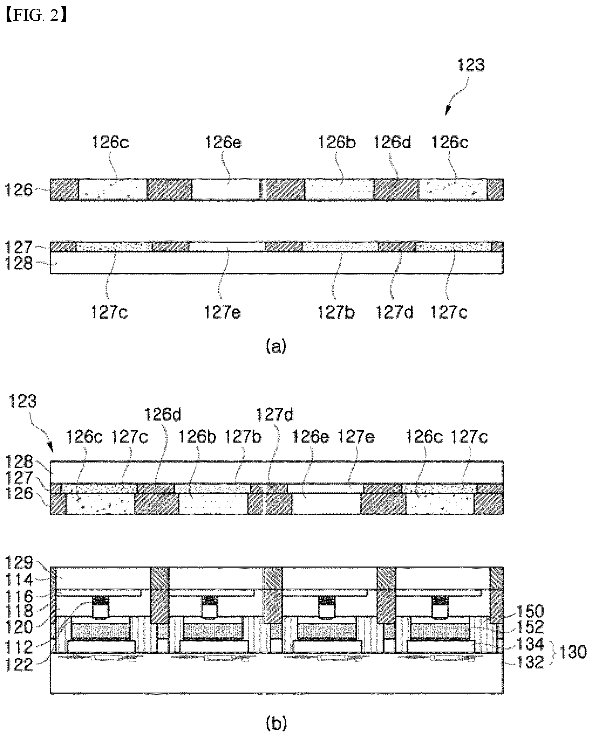

FIG. 1 is a sectional view of a display apparatus according to a first exemplary embodiment of the present disclosure and FIG. 2 is sectional views illustrating a method of manufacturing the display apparatus according to the first exemplary embodiment of the present disclosure.

Referring to FIG. 1, the display apparatus 100 according to the first exemplary embodiment includes a light emitting diode part 110, a TFT panel part 130, and an anisotropic conductive film 150.

The light emitting diode part 110 includes light emitting diodes 112a, a support substrate 114, transparent electrodes 116, a first blocking portion 118, an insulation layer 120, first connection electrodes 122, a phosphor layer 126, a color filter 127, and a protective substrate 128.

The light emitting diode part 110 includes a plurality of light emitting diodes 112a, which are regularly arranged on the support substrate 114. For example, the plurality of light emitting diodes 112a may be arranged at constant intervals in a matrix form. In this exemplary embodiment, the plurality of light emitting diodes 112a may include blue light emitting diodes emitting blue light.

In the display apparatus 100 according to this exemplary embodiment, the light emitting diode part 110 may be driven by power applied from an exterior power source. That is, an image can be reproduced through on-off combination of the light emitting diodes 112a in the light emitting diode part 110 and the wavelength of light emitted from the light emitting diodes 112a is converted into emit red light, green light and blue light through the phosphor layer 126. Accordingly, the display apparatus 100 can be driven without a separate LCD. In this exemplary embodiment, a region including a single light emitting diode 112a may be used as a subpixel in the display apparatus 100. In the light emitting diode part 110, one subpixel may have a larger size than the light emitting diode 112a disposed in the subpixel.

Referring to FIG. 1, each of the light emitting diodes 112a includes an n-type semiconductor layer 23, an active layer 25, a p-type semiconductor layer 27, an n-type electrode 31, a p-type electrode 33, and a wall 35.

The n-type semiconductor layer 23, the active layer 25 and the p-type semiconductor layer 27 may include Group III-V based compound semiconductors. By way of example, the n-type semiconductor layer 23, the active layer 25 and the p-type semiconductor layer 27 may include nitride semiconductors such as (Al, Ga, In)N. In other exemplary embodiments, locations of the n-type semiconductor layer 23 and the p-type semiconductor layer 27 can be interchanged.

The n-type semiconductor layer 23 may include an n-type dopant (for example, Si) and the p-type semiconductor layer 27 may include a p-type dopant (for example, Mg). The active layer 25 is interposed between the n-type semiconductor layer 23 and the p-type semiconductor layer 27. The active layer 25 may have a multiquantum well (MQW) structure and the composition of the active layer 25 may be determined so as to emit light having a desired peak wavelength.

In addition, the light emitting structure including the n-type semiconductor layer 23, the active layer 25 and the p-type semiconductor layer 27 may be formed similar to a vertical type light emitting diode 112a. In this structure, the n-type electrode 31 may be formed on an outer surface of the n-type semiconductor layer 23 and the p-type electrode 33 may be formed on an outer surface of the p-type semiconductor layer 27.

Further, as shown in FIG. 1, a bonding portion S may be formed between the p-type electrode 33 and the transparent electrode 116 in order to couple the light emitting diode 112a similar to the vertical type light emitting diode to the transparent electrode 116 formed on the support substrate 114. Here, the wall 35 may be formed on the light emitting diode 112a to prevent the bonding portion S from escaping from a space between the p-type electrode 33 and the transparent electrode 116.

The wall 35 may be formed to cover a portion of the p-type electrode 33 such that the p-type electrode 33 can be exposed on the p-type semiconductor layer 27, and may be composed of a plurality of layers, as shown in the drawings. The wall 35 may include a first layer and a second layer, and may be formed by forming the first layer including SiN on the p-type semiconductor layer 27 so as to cover a portion of the p-type electrode 33, followed by forming the second layer including SiO2 on the first layer. The second layer may have a greater thickness and a smaller width than the first layer.

The support substrate 114 is a substrate on which the plurality of light emitting diodes 112a will be mounted, and may be an insulation substrate, a conductive substrate, or a printed circuit board. By way of example, the support substrate 114 may be at least one of a sapphire substrate, a gallium nitride substrate, a glass substrate, a silicon carbide substrate, a silicon substrate, a metal substrate, and a ceramic substrate. In this exemplary embodiment, the support substrate 114 may be a transparent substrate in order to allow light emitted from the light emitting diodes 112a to pass therethrough. By way of example, the support substrate 114 may be a flexible glass substrate having a certain thickness.

In this exemplary embodiment, the support substrate 114 is formed of a transparent material and light emitted from the plurality of light emitting diodes 112a can be emitted to the outside through the support substrate 114 and through the phosphor layer 126 and the color filter 127 formed on an upper surface of the support substrate 114. The support substrate 114 is divided into a plurality of support substrates separated from each other so as to be placed only on the light emitting diodes 112a, respectively. In addition, each of a plurality of second blocking portions 129 may be disposed in a space between the support substrates 114.

The second blocking portion 129 blocks light emitted from one light emitting diode 112a from traveling towards another light emitting diode 112a adjacent thereto. That is, each of the second blocking portions 129 is disposed between the support substrates 114 such that light emitted from one light emitting diode 112a can be discharged to the outside through the support substrate 114 disposed on the light emitting diode 112a and through the phosphor layer 126 and the color filter 127 thereon.

The transparent electrode 116 may be formed on the support substrate 114 and may be electrically connected to the p-type electrode 33 of the light emitting diode 112. In this exemplary embodiment, a plurality of transparent electrodes 116 may be formed on the support substrate 114 and may be coupled to the plurality of light emitting diodes 112, respectively. Alternatively, the plurality of light emitting diodes 112 may be coupled to one transparent electrode 116, as needed. In addition, the transparent electrodes 116 may be separated from each other on the support substrate 114. By way of example, the transparent electrodes 116 may be formed of indium tin oxide (ITO) and the like.

The first blocking portion 118 is formed on the support substrate 114 and may be provided in plural. The first blocking portion 118 prevents light emitted from a certain light emitting diode from being directed towards other light emitting diodes 112 adjacent thereto when light emitted from the light emitting diodes 112 is emitted to the outside through the transparent electrodes 116. Accordingly, each of the first blocking portions 118 may be formed between the transparent electrodes 116 separated from each other and may be formed to cover a portion of each of the transparent electrodes 116, as needed. **In** this exemplary embodiment, the first blocking portion 118 may be formed of aluminum (Al) or chromium (Cr).

The insulation layer 120 may surround the light emitting diode 112a and cover an exposed surface of a connecting plane between the light emitting diode 112a and the transparent electrode 116 while covering the transparent electrode 116. **In** the structure wherein the insulation layer 120 surrounds the light emitting diode 112a, the n-type semiconductor layer 23 and the n-type electrode 31 of the light emitting diode 112a can be exposed through the insulation layer 120.

The first connection electrode 122 covers the insulation layer 120 and may also cover the n-type semiconductor layer 23 and the n-type electrode 31 not covered by the insulation layer 120. Accordingly, the first connection electrode 122 may be electrically connected to the n-type semiconductor layer 23.

The phosphor layer 126 may be formed on an upper surface of the support substrate 114, and may include a green phosphor layer 126b, a red phosphor layer 126c and a transparent layer 126e. The green phosphor layer 126b, the red phosphor layer 126c and the transparent layer 126e may be alternately arranged to be adjacent to one another or to be separated from one another by a predetermined distance or greater. A blocking layer 126d is disposed between the green phosphor layer 126b, the red phosphor layer 126c and the transparent layer 126e separated a predetermined distance from one another. The blocking layer 126d may be formed while filling spaces between the green phosphor layer 126b, the red phosphor layer 126c and the transparent layer 126e, and prevents light emitted through each of the green phosphor layer 126b, the red phosphor layer 126c and the transparent layer 126e from traveling towards another phosphor layer adjacent thereto.

In this exemplary embodiment, the light emitting diodes 112 are blue light emitting diodes. Accordingly, the green phosphor layer 126b converts the wavelength of blue light emitted from the light emitting diodes 112a to emit green light and the red phosphor layer 126c converts the wavelength of blue light emitted from the blue light emitting diodes 112a to emit red light. In addition, the transparent layer 126e allows blue light emitted from the light emitting diodes 112a to pass therethrough without wavelength conversion. Accordingly, green light, red light and blue light can be emitted through the phosphor layer 126.

The color filter 127 may be disposed on an upper surface of the phosphor layer 126, and may include a green light portion 127b, a red light portion 127c, a light blocking portion 127d, and a transparent portion 127e. The color filter 127 may be formed in a film shape and can block light having passed through the color filter 127 excluding light of a predetermined wavelength having passed therethrough.

That is, the green light portion 127b allows only green light to pass therethrough by blocking light having other wavelengths than the wavelength of the green light, and the red light portion 127c allows only red light to pass therethrough by blocking light having other wavelengths than the red light. In addition, the light blocking portion 127d is disposed between the green light portion 127b, the red light portion 127c and the transparent portion 127e, and blocks all components of light. In addition, the transparent portion 127e allows light to pass therethrough without wavelength conversion.

In this exemplary embodiment, the green light portion 127b, the red light portion 127c and the transparent portion 127e of the color filter 127 may be arranged in the same manner as those of the phosphor layer 126. That is, the green light portion 127b of the color filter 127 is disposed on an upper surface of the green phosphor layer 126b and the red light portion 127c thereof is disposed on an upper surface of the red phosphor layer 126c. Further, the transparent portion 127e may be disposed on an upper surface of the transparent layer 126e through which blue light emitted from the light emitting diodes 112a passes without wavelength conversion.

In this exemplary embodiment, the green light portion 127b, the red light portion 127c and the transparent portion 127e may have greater widths than the green phosphor layer 126b, the red phosphor layer 126c and the transparent layer 126e, respectively. As a result, the entirety of light having passed through the phosphor layer 126 can be discharged to the outside through the color filter 127.

As such, in this exemplary embodiment, since the red light portion 127c is disposed on the upper surface of the red phosphor layer 126c, light of other wavelengths included in light having passed through the red phosphor layer 126c can be blocked by the red light portion 127c and only red light can be discharged through the red light portion 127c. In addition, since the green light portion 127b is disposed on the upper surface of the green phosphor layer 126b, light of other wavelengths included in light having passed through the green phosphor layer 126b can be blocked by the green light portion 127b and only green light can be discharged through the green light portion 127b.

That is, blue light emitted from the light emitting diodes 112a is converted into red light while passing through the red phosphor layer 126c, and a fraction of the blue light not subjected to wavelength conversion can be discharged to the outside. Likewise, blue light emitted from the light emitting diodes 112a is converted into green light while passing through the green phosphor layer 126b, such that the green light can be discharged to the outside together with a fraction of the blue light. In this way, since a fraction of blue light passes through the phosphor layer 126 without wavelength conversion and causes deterioration in color purity, the color filter 127 can completely block this fraction of blue light so as to allow a pure color obtained through wavelength conversion to be discharged to the outside.

Alternatively, in order to reduce the fraction of blue light not subjected to wavelength conversion, the thickness of the phosphor layer 126 can be reduced so as to convert the wavelength of light emitted from the light emitting diodes 112a, instead of using the color filter 127. In this case, however, the intensity of light can be reduced with increasing thickness of the phosphor layer 126. Therefore, the thickness of the phosphor layer 126 and the use of the color filter 127 may be suitably adjusted so as to emit a desired color.

The protective substrate 128 is disposed on an upper surface of the color filter 127 and can protect the color filter 127 from an external environment by preventing the color filter 127 from being directly exposed to the outside. In this exemplary embodiment, the protective substrate 128 may be formed of a transparent material like the support substrate 114.

The TFT panel part 130 includes a panel substrate 132 and second connection electrodes 134, and is coupled to the light emitting diode part 110 to supply power to the light emitting diode part 110. The TFT panel part 130 may control power supply to the light emitting diode part 110 to allow only some of the light emitting diodes 112a in the light emitting diode part 110 to emit light.

The panel substrate 132 has a TFT drive circuit therein. The TFT drive circuit may be a circuit for driving an active matrix (AM) or a circuit for driving a passive matrix (PM).

The second connection electrodes 134 may be electrically connected to the TFT drive circuit of the panel substrate 132 and to the first connection electrodes 122 of the light emitting diode part 110. In this structure, power supplied through the TFT drive circuit can be supplied to each of the light emitting diodes 112a through the first and second connection electrodes 122, 134. In this exemplary embodiment, the second connection electrodes 134 may be covered by a separate protective layer, which may include, for example, SiNx.

The anisotropic conductive film 150 serves to electrically connect the light emitting diode part 110 to the TFT panel part 130. The anisotropic conductive film 150 may include an adhesive organic insulation material and may contain conductive particles uniformly dispersed therein to achieve electrical connection. The anisotropic conductive film 150 exhibits conductivity in the thickness direction thereof and insulating properties in the plane direction thereof. In addition, the anisotropic conductive film 150 exhibits adhesive properties. Thus, the anisotropic conductive film 150 may be used to bond the light emitting diode part 110 to the TFT panel part 130 such that the light emitting diode part 110 can be electrically connected to the TFT panel part 130 therethrough. Particularly, the anisotropic conductive film 150 may be advantageously used to connect ITO electrodes which are difficult to solder at high temperature.

As such, in the structure wherein the light emitting diodes 112a are coupled to the TFT panel part 130 via the anisotropic conductive film 150, the first connection electrodes 122 of the light emitting diode part 110 may be electrically connected to the second connection electrodes 134 of the TFT panel part 130 via an electrode connection portion 152.

In this exemplary embodiment, the light emitting diode part 110 and the TFT panel part 130 may be separately manufactured, and a light converter 123 of the light emitting diode part 110 may also be separately manufactured. According to the invention, the light converter 123 includes the phosphor layer 126. In this exemplary embodiment, the light converter 123 includes the color filter 127, and the protective substrate 128. That is, as shown in FIG. 2 (a), the color filter 127 is formed on the protective substrate 128 and the phosphor layer 126 is formed on the color filter 127, thereby providing the light converter 123. As shown in FIG. 2 (b), with the light emitting diode part 110 coupled to the TFT panel part 130, the light converter 123 is coupled to the upper surface of the support substrate 114 such that the phosphor layers face the light emitting diode part 110, thereby providing the display apparatus 100.

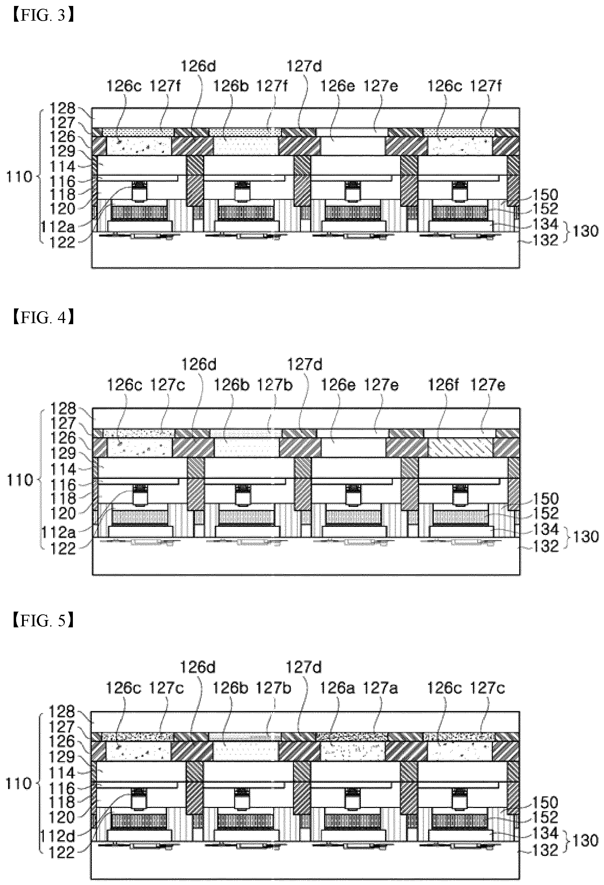

FIG. 3 is a sectional view of a display apparatus according to a second exemplary embodiment of the present disclosure.

Referring to FIG. 3, the display apparatus 100 according to the second exemplary embodiment includes a light emitting diode part 110, a TFT panel part 130, and an anisotropic conductive film 150. In description of this exemplary embodiment, descriptions of the same components as those of the first exemplary embodiment will be omitted.

According to this exemplary embodiment, the color filter 127 includes a transparent portion 127e, a wavelength filter unit 127f, and a light blocking portion 127d. As in the first exemplary embodiment, the transparent portion 127e is disposed on an upper surface of the transparent layer 126e of the phosphor layer 126, and the wavelength filter unit 127f is disposed on an upper surface of each of the green phosphor layer 126b and the red phosphor layer 126c of the phosphor layer 126. Accordingly, the wavelength filter unit 127f and the transparent layer 126e are provided in plural and are separated from each other. The light blocking portion 127d may be disposed in a space between the wavelength filter unit 127f and the transparent layer 126e.

The wavelength filter unit 127f allows light of a predetermined wavelength or more among light having passed through the green phosphor layer or the red phosphor layer to pass therethrough. That is, in this exemplary embodiment, the light emitting diodes 112a emit blue light, which is converted into red light or green light while passing through the phosphor layer 126. Accordingly, the wavelength filter unit 127f may allow light of a predetermined wavelength or more among light having passed through the red phosphor layer 126c or the green phosphor layer 126b, while blocking blue light, which has a shorter wavelength than the predetermined wavelength, (for example, the wavelength filter unit 127f may block light having a wavelength of 480 nm or less).

Furthermore, in this exemplary embodiment, each of the wavelength filter unit 127f and the transparent portion 127e may have a greater width than the green phosphor layer 126b, the red phosphor layer 126c and the transparent layer 126e.

FIG. 4 is a sectional view of a display apparatus according to a third exemplary embodiment of the present disclosure.

Referring to FIG. 4, the display apparatus 100 according to the third exemplary embodiment includes a light emitting diode part 110, a TFT panel part 130, and an anisotropic conductive film 150. In description of this exemplary embodiment, descriptions of the same components as those of the first exemplary embodiment will be omitted.

In this exemplary embodiment, the phosphor layer 126 may include a green phosphor layer 126b, a red phosphor layer 126c, a transparent layer 126e, a white phosphor layer 126f, and a blocking layer 126d. In addition, the color filter 127 may include a green light portion 127b, a red light portion 127c, a transparent portion 127e, and a light blocking portion 127d.

Accordingly, the green phosphor layer 126b, the red phosphor layer 126c, the transparent layer 126e and the white phosphor layer 126f may be alternately arranged to be adjacent to one another or to be separated from one another by a predetermined distance or greater. The blocking layer 126d may be disposed between the green phosphor layer 126b, the red phosphor layer 126c, the transparent layer 126e and the white phosphor layer 126f separated from one another.

Furthermore, in the color filter 127, the green light portion 127b may be disposed on an upper surface of the green phosphor layer 126b, the red light portion 127c may be disposed on an upper surface of the red phosphor layer 126c, and the transparent portion 127e may be disposed on an upper surface of each of the transparent layer 126e and the white phosphor layer 126f. In this structure, green light can be emitted through the green light portion 127b and red light can be emitted through the red light portion 127c. In addition, blue light can be emitted through the transparent layer 126e and the transparent portion 127e, and white light can be emitted through the white phosphor layer 126f and the transparent portion 127e.

That is, in the display apparatus 100 according to this exemplary embodiment, four subpixels emitting blue light, green light, red light and white light, respectively, may be driven as one pixel.

FIG. 5 is a sectional view of a display apparatus according to a fourth exemplary embodiment of the present disclosure.

Referring to FIG. 5, the display apparatus 100 according to the fourth exemplary embodiment includes a light emitting diode part 110, a TFT panel part 130, and an anisotropic conductive film 150. In description of this exemplary embodiment, descriptions of the same components as those of the first exemplary embodiment will be omitted.

In this exemplary embodiment, the light emitting diodes of the light emitting diode part 110 are UV light emitting diodes 112d. Thus, the phosphor layer 126 may include a blue phosphor layer 126a, a green phosphor layer 126b, a red phosphor layer 126c and a blocking layer 126d, and the color filter 127 may include a blue light portion 127a, a green light portion 127b, a red light portion 127c and a light blocking portion 127d.

In the phosphor layer 126, the blue phosphor layer 126a, the green phosphor layer 126b and the red phosphor layer 126c may be disposed on upper surfaces of the UV light emitting diodes 112d, respectively, and may be alternately arranged to be adjacent to one another or to be separated from one another by a predetermined distance or greater. The blocking layer 126d may be disposed between the blue phosphor layer 126a, the green phosphor layer 126b, and the red phosphor layer 126c.

In this exemplary embodiment, the blue phosphor layer 126a converts the wavelength of UV light emitted from the UV light emitting diode 112d to emit blue light, the green phosphor layer 126b converts the wavelength of UV light emitted from the UV light emitting diode 112d to emit green light, and the red phosphor layer 126c converts the wavelength of UV light emitted from the UV light emitting diode 112d to emit red light.

Furthermore, in the color filter 127, the blue light portion 127a may be disposed on an upper surface of the blue phosphor layer 126a, the green light portion 127b may be disposed on an upper surface of the green phosphor layer 126b, and the red light portion 127c may be disposed on an upper surface of the red phosphor layer 126c. That is, the blue light portion 127a, the green light portion 127b and the red light portion 127c may be disposed on the upper surfaces of the blue phosphor layer 126a, the green phosphor layer 126b and the red phosphor layer 126c, respectively, and may be alternately arranged to be adjacent to one another. In addition, the blue light portion 127a, the green light portion 127b and the red light portion 127c may be separated from one another by a predetermined distance or greater, and the light blocking portion 127d may be disposed between the blue light portion 127a, the green light portion 127b and the red light portion 127c separated from one another.

Light having passed through the blue phosphor layer 126a may include blue light subjected to wavelength conversion and UV light not subjected to wavelength conversion, and the blue light portion 127a allows only the blue light to be discharged to the outside by blocking the UV light among the light having passed through the blue phosphor layer 126a. In addition, light having passed through the green phosphor layer 126b may include green light subjected to wavelength conversion and UV light not subjected to wavelength conversion, and the green light portion 127b allows only the green light to be discharged to the outside by blocking the UV light among the light having passed through the green phosphor layer 126b. Furthermore, light having passed through the red phosphor layer 126c may include red light subjected to wavelength conversion and UV light not subjected to wavelength conversion, and the red light portion 127c allows only the red light to be discharged to the outside by blocking the UV light among the light having passed through the red phosphor layer 126c.

Although certain exemplary embodiments have been described herein, it should be understood by those skilled in the art that these embodiments are given by way of illustration only, and that various modifications, variations, and alterations can be made without departing from the scope of the invention. Therefore, the scope of the invention should be limited only present invention as defined the accompanying claims.

**<List of Reference Numerals>**

| | | | |
|---|---|---|---|
| 100: | display apparatus | | |
| 110: | light emitting diode | | |
| 112a: | light emitting diode | 112d: | UV diode |
| 23: | n-type semiconductor layer | 25: | active layer |
| 27: | p-type semiconductor layer | 31: | n-type electrode |
| 33: | p-type electrode | 35: | wall |
| 114: | support substrate | 116: | transparent electrode |
| 118: | first blocking portion | 120: | insulation layer |
| 122: | first connection electrode | | |
| 123: | light converter | 126: | phosphor layer |
| 126a: | blue phosphor layer | 126b: | green phosphor layer |
| 126c: | red phosphor layer | 126d: | blocking layer |
| 126e: | transparent layer | 126f: | white phosphor layer |
| 127: | color filter | 127a: | blue light portion |
| 127b: | green light portion | 127c: | red light portion |
| 127d: | light blocking portion | 127e: | transparent portion |
| 127f: | wavelength filter unit | | |
| 128: | protective substrate | 129: | second blocking portion |
| 130: | TFT panel part | 132: | panel substrate |
| 134: | second connection electrode | | |
| 150: | anisotropic conductive film | 152: | electrode connection portion |
| S: | bonding portion | | |

## Claims

1. A display apparatus comprising:
a first substrate (114) including a plurality of light emitting diodes (112a) regularly arranged thereon;
a second substrate (132) comprising a TFT panel part (130) comprising a plurality of TFTs driving the plurality of light emitting diodes; and
a third substrate including a light converter (123) disposed over the plurality of light
emitting diodes and comprising phosphor layers and light blocking layers(126d).
wherein:
the plurality of light emitting diodes are coupled to the TFT panel part and
electrically connected to the TFTs, respectively;
light emitted from the plurality of light emitting diodes is converted into at least one of blue light, green light, and red light through the light converter;
the display apparatus includes subpixels each of which comprises single light emitting diode and emits one of blue light, green light, and red light;
each of the subpixels has a larger size than the light emitting diode in the corresponding subpixel,
wherein the phosphor layers are arranged to be separated from one another by a predetermined distance,
the third substrate is coupled to the first substrate such that the phosphor layers face the light emitting diodes, and
the light blocking layers are disposed between the phosphor layers such that the light blocking layers prevent light emitted through each of the phosphor layers from travelling towards another phosphor layer adjacent thereto.

2. The display apparatus according to claim 1,
wherein the light emitting diodes (112a) comprise blue light emitting diodes; the light converter (123) comprises a green phosphor layer (126b) emitting green light through wavelength conversion of blue light emitted from the blue light emitting diode, a red phosphor layer(126c) emitting red light through wavelength conversion of blue light emitted from the blue light emitting diode, and a transparent layer(126e) allowing blue light emitted from the blue light emitting diode to pass therethrough without wavelength conversion.

3. The display apparatus according to claim 2,
wherein the light blocking layers are further disposed between the phosphor layers and
the transparent layer.

4. The display apparatus according to claim 1,
wherein the light emitting diodes(112a) comprise blue light emitting diodes;
the light converter(123) comprises a green phosphor layer(126b) emitting green light through wavelength conversion of blue light emitted from the blue light emitting diode, a red phosphor layer(126c) emitting red light through wavelength conversion of blue light emitted from the blue light emitting diode, a transparent layer(126e) allowing blue light emitted from the blue light emitting diode to pass therethrough without wavelength conversion, and a white phosphor layer(126f) emitting white light through wavelength conversion of blue light emitted from the blue light emitting diode.

5. The display apparatus according to claim 1,
wherein the light emitting diodes(112a) comprise UV light emitting diodes emitting UV light;
the light converter (123) comprises a blue phosphor layer(126a) emitting blue light through wavelength conversion of UV light emitted from the UV light emitting diode, a green phosphor layer(126b) emitting green light through wavelength conversion of UV light emitted from the UV light emitting diode, and a red phosphor layer(126c) emitting red light through wavelength conversion of UV light emitted from the UV light emitting diode.

6. The display apparatus according to claim 1, wherein each of the plurality of light emitting diodes comprises:
an n-type semiconductor layer;
a p-type semiconductor layer;
an active layer interposed between the n-type semiconductor layer and the p-type semiconductor layer;
an n-type electrode coupled to the n-type semiconductor layer; and
a p-type electrode coupled to the p-type semiconductor layer.

7. The display apparatus according to claim 1, further comprising:
an anisotropic conductive film electrically connecting the plurality of light emitting diodes to the TFTs.

8. The display apparatus according to claim 1, further comprising:
a first light blocking portion (118) disposed between the light emitting diodes(112a) and
preventing light emitted from a light emitting diode from being directed to adjacent light emitting diodes.

9. The display apparatus according to claim 1, wherein the first substrate is a support substrate (114).

10. The display apparatus according to claim 9,
wherein the support substrate (114) comprises a sapphire substrate, a gallium nitride substrate, a glass substrate, a silicon carbide substrate, a silicon substrate, a metal substrate, or a ceramic substrate.

11. The display apparatus according to claim 9, further comprising:
second light blocking portions (129),
wherein the support substrate (114) is divided into a plurality of support substrates separated from one another, and the second light blocking portions are disposed
between the divided support substrates.

12. The display apparatus according to claim 9,
wherein the phosphor layers are disposed over the support substrate, and light emitted from the light emitting diodes are directed to the phosphor layers through the support substrate.

13. The display apparatus according to claim 1,
wherein the plurality of light emitting diodes(112a) is arranged at constant intervals in a matrix form.

## Patentansprüche

1. Anzeigevorrichtung, umfassend:
ein erstes Substrat (114) mit einer Vielzahl von darauf regelmäßig angeordneten lichtemittierenden Dioden (112a);
ein zweites Substrat (132) mit einem TFT-Panel-Teil (130), der eine Vielzahl von TFTs umfasst, die die Vielzahl von lichtemittierenden Dioden ansteuern; und
ein drittes Substrat mit einem Lichtkonverter (123), der über der Vielzahl von lichtemittierenden Dioden angeordnet ist und Phosphorschichten und
lichtblockierende Schichten (126d) umfasst,
wobei:
die mehreren lichtemittierenden Dioden mit dem TFT-Panelteil gekoppelt und jeweils elektrisch mit den TFTs verbunden sind;
Das von der Vielzahl der lichtemittierenden Dioden emittierte Licht wird durch den Lichtkonverter in mindestens eines von blauem Licht, grünem Licht und rotem Licht umgesetzt.
die Anzeigevorrichtung Unterpixel umfasst, von denen jedes eine einzelne lichtemittierende Diode umfasst und entweder blaues Licht, grünes Licht oder rotes Licht emittiert;
jedes der Subpixel eine größere Größe als die lichtemittierende Diode im entsprechenden Subpixel aufweist,
wobei die Leuchtstoffschichten so angeordnet sind, dass sie durch einen vorbestimmten Abstand voneinander getrennt sind, und
das dritte Substrat ist mit dem ersten Substrat so gekoppelt, dass die Phosphorschichten den lichtemittierenden Dioden zugewandt sind, und
die lichtblockierenden Schichten zwischen den Phosphorschichten angeordnet sind, so dass die blockierenden Schichten verhindern, dass das durch jede der Phosphorschichten emittierte Licht zu einer anderen, daran angrenzenden Phosphorschicht gelangt.

2. Anzeigevorrichtung nach Anspruch 1,
wobei die Leuchtdioden (112a) blaue Leuchtdioden umfassen;
der Lichtkonverter (123) umfasst eine grüne Phosphorschicht (126b), die durch Wellenlängenumwandlung des von der blauen Leuchtdiode emittierten blauen Lichts grünes Licht emittiert, eine rote Phosphorschicht (126c), die durch Wellenlängenumwandlung des von der blauen Leuchtdiode emittierten blauen Lichts rotes Licht emittiert und eine transparente Schicht (126e), die das von der blauen lichtemittierenden Leuchtdiode emittierte blaue Licht ohne Wellenlängenumwandlung durchlässt.

3. Anzeigevorrichtung gemäß Anspruch 2,
wobei die lichtblockierenden Schichten ferner zwischen den Phosphorschichten und der transparenten Schicht angeordnet sind.

4. Anzeigevorrichtung nach Anspruch 1,
wobei die lichtemittierenden Dioden (112a) blaue lichtemittierende Dioden umfassen; der Lichtkonverter (123) eine grüne Phosphorschicht (126b) umfasst, die durch Wellenlängenumwandlung des von der blauen Leuchtdiode emittierten blauen Lichts grünes Licht emittiert, eine rote Phosphorschicht (126c), die durch Wellenlängenumwandlung des von der blauen Leuchtdiode emittierten blauen Lichts rotes Licht emittiert, eine transparente Schicht (126e), die das von der blauen Leuchtdiode emittierte blaue Licht ohne Wellenlängenumwandlung durchlässt, und eine weiße Phosphorschicht (126f), die durch Wellenlängenumwandlung des von der blauen Leuchtdiode emittierten blauen Lichts weißes Licht emittiert.

5. Anzeigevorrichtung nach Anspruch 1,
wobei die Leuchtdioden (112a) UV-Licht emittierende Leuchtdioden umfassen, die UV-Licht emittieren;
der Lichtkonverter (123) umfasst eine blaue Phosphorschicht (126a), die durch Wellenlängenumwandlung des von der UV-Licht emittierenden Diode emittierten UV-Lichts blaues Licht emittiert, eine grüne Phosphorschicht (126b), die durch Wellenlängenumwandlung des von der UV-Licht emittierenden Diode emittierten UV-Lichts grünes Licht emittiert und eine rote Phosphorschicht (126c), die durch Wellenlängenumwandlung des von der UV-Licht emittierenden Diode emittierten UV-Lichts rotes Licht emittiert.

6. Anzeigevorrichtung nach Anspruch 1, wobei jede der mehreren Lichteemittierenden Dioden umfasst:
eine n-Typ-Halbleiterschicht;
eine p-Typ-Halbleiterschicht;
eine aktive Schicht, die zwischen der n-Halbleiterschicht und der p-Halbleiterschicht angeordnet ist;
eine mit der n-Halbleiterschicht gekoppelte n-Elektrode; und
eine mit der p-Halbleiterschicht gekoppelte p-Elektrode.

7. Anzeigevorrichtung nach Anspruch 1, die ferner umfasst:
einen anisotropen leitfähigen Film, der die mehreren lichtemittierenden Dioden elektrisch mit den TFTs verbindet.

8. Anzeigevorrichtung nach Anspruch 1, die ferner umfasst:
einen ersten lichtblockierenden Abschnitt (118), der zwischen den lichtemittierenden Dioden (112a) angeordnet ist und verhindert, dass von einer lichtemittierenden Diode emittiertes Licht auf benachbarte lichtemittierende Dioden gelenkt wird.

9. Anzeigevorrichtung nach Anspruch 1, wobei das erste Substrat ein ein Trägersubstrat (114) ist.

10. Anzeigevorrichtung nach Anspruch 9,
wobei das Trägersubstrat (114) ein Saphirsubstrat, ein Galliumnitridsubstrat, ein Glassubstrat, ein Siliziumkarbid-Substrat, ein Siliziumsubstrat, ein Metallsubstrat oder ein Keramiksubstrat umfasst.

11. Anzeigevorrichtung nach Anspruch 9, die ferner umfasst:
zweite lichtblockierende Abschnitte (129),
wobei das Trägersubstrat (114) in eine Vielzahl von voneinander getrennten Trägersubstraten unterteilt ist und die zweiten lichtblockierenden Abschnitte zwischen den unterteilten Trägersubstraten angeordnet sind.

12. Anzeigevorrichtung nach Anspruch 9,
wobei die Leuchtstoffschichten über dem Trägersubstrat angeordnet sind und das von den lichtemittierenden Dioden emittierte Licht durch das Trägersubstrat auf die Leuchtstoffschichten gerichtet wird.

13. Anzeigevorrichtung nach Anspruch 1,
wobei die mehreren lichteemittierenden Dioden (112a) in konstanten Abständen in Matrixform angeordnet sind.

## Revendications

1. Dispositif d'affichage comprenant:
un premier substrat (114) comprenant une pluralité de diodes électroluminescentes (112a) disposées régulièrement sur celui-ci;
un deuxième substrat (132) comprenant une partie de panneau TFT (130) comprenant une pluralité de TFT commandant la pluralité de diodes électroluminescentes; et
un troisième substrat comprenant un convertisseur de lumière (123) disposé au-dessus de la pluralité de diodes électroluminescentes et comprenant des couches de phosphore et des couches bloquant la lumière (126d),
dans lequel:
la pluralité de diodes électroluminescentes sont couplées à la partie panneau TFT et connectées électriquement aux TFT, respectivement;
la lumière émise par la pluralité de diodes électroluminescentes est convertie en au moins une lumière parmi la lumière bleue, la lumière verte et la lumière rouge par le convertisseur de lumière;
le dispositif d'affichage comprend des sous-pixels dont chacun comprend une seule diode électroluminescente et émet l'une parmi la lumière bleue, la lumière verte et la lumière rouge;
chacun des sous-pixels a une taille plus grande que la diode électroluminescente dans le sous-pixel correspondant,
dans lequel les couches de phosphore sont agencées de manière à être séparées les unes des autres par une distance prédéterminée, et
le troisième substrat est couplé au premier substrat de telle sorte que les couches de phosphore soient face aux diodes électroluminescentes, et
les couches bloquant la lumière sont disposées entre les couches de phosphore de telle sorte que les couches bloquantes empêchent la lumière émise à travers chacune des couches de phosphore de se propager vers une autre couche de phosphore adjacente à celle-ci.

2. Dispositif d'affichage selon la revendication 1,
dans lequel les diodes électroluminescentes (112a) comprennent des diodes électroluminescentes bleues;
le convertisseur de lumière (123) comprend une couche de phosphore verte (126b) émettant de la lumière verte par conversion de longueur d'onde de la lumière bleue émise par la diode électroluminescente bleue, une couche de phosphore rouge (126c) émettant de la lumière rouge par conversion de longueur d'onde de la lumière bleue émise par la diode électroluminescente bleue, et une couche transparente (126e) permettant à la lumière bleue émise par la diode électroluminescente bleue de passer à travers sans conversion de longueur d'onde.

3. Dispositif d'affichage selon la revendication 2,
dans lequel les couches bloquant la lumière sont en outre disposées entre les couches de phosphore et la couche transparente.

4. Dispositif d'affichage selon la revendication 1,
dans lequel les diodes électroluminescentes (112a) comprennent des diodes électroluminescentes bleues;
le convertisseur de lumière (123) comprend une couche de phosphore vert (126b) émettant de la lumière verte par conversion de longueur d'onde de la lumière bleue émise par la diode électroluminescente bleue, une couche de phosphore rouge (126c) émettant de la lumière rouge par conversion de longueur d'onde de la lumière bleue émise par la diode électroluminescente bleue, une couche transparente (126e) laissant passer la lumière bleue émise par la diode électroluminescente bleue sans conversion de longueur d'onde, et une couche de phosphore blanc (126f) émettant de la lumière blanche par conversion de longueur d'onde de la lumière bleue émise par la diode électroluminescente bleue.

5. Dispositif d'affichage selon la revendication 1,
dans lequel les diodes électroluminescentes (112a) comprennent des diodes électroluminescentes UV émettant de la lumière UV;
le convertisseur de lumière (123) comprend une couche de phosphore bleu (126a) émettant de la lumière bleue par conversion de longueur d'onde de la lumière UV émise par la diode électroluminescente UV, une couche de phosphore vert (126b) émettant de la lumière verte par conversion de longueur d'onde de la lumière UV émise par la diode électroluminescente UV, et une couche de phosphore rouge (126c) émettant de la lumière rouge par conversion de longueur d'onde de la lumière UV émise par la diode électroluminescente UV.

6. Dispositif d'affichage selon la revendication 1, dans lequel chacune des multiples diodes électroluminescentes comprend:
une couche semi-conductrice de type n;
une couche semi-conductrice de type p;
une couche active interposée entre la couche semi-conductrice de type n et la couche semi-conductrice de type p;
une électrode de type n couplée à la couche semi-conductrice de type n; et
une électrode de type p couplée à la couche semi-conductrice de type p.

7. Dispositif d'affichage selon la revendication 1, comprenant en outre:
un film conducteur anisotrope reliant électriquement la pluralité de diodes électroluminescentes aux TFT.

8. Dispositif d'affichage selon la revendication 1, comprenant en outre :
une première partie bloquant la lumière (118) disposée entre les diodes électroluminescentes (112a) et empêchant la lumière émise par une diode électroluminescente d'être dirigée vers les diodes électroluminescentes adjacentes.

9. Dispositif d'affichage selon la revendication 1, dans lequel le premier substrat est un substrat de support (114).

10. Dispositif d'affichage selon la revendication 9,
dans lequel le substrat de support (114) comprend un substrat en saphir, un substrat en nitrure de gallium, un substrat en verre, un substrat en carbure de silicium, un substrat en silicium, un substrat métallique ou un substrat céramique.

11. Dispositif d'affichage selon la revendication 9, comprenant en outre:
des secondes parties bloquant la lumière (129),
dans lequel le substrat de support (114) est divisé en une pluralité de substrats de support séparés les uns des autres, et les secondes parties bloquant la lumière sont disposées entre les substrats de support divisés.

12. Dispositif d'affichage selon la revendication 9,
dans lequel les couches de phosphore sont disposées sur le substrat de support, et la lumière émise par les diodes électroluminescentes est dirigée vers les couches de phosphore à travers le substrat de support.

13. Dispositif d'affichage selon la revendication 1,
dans lequel la pluralité de diodes électroluminescentes (112a) est disposée à intervalles constants sous forme de matrice.
